(19) Europäisches Patentamt
European Patent Office
Office européen des brevets

(11) **EP 4 579 258 A1**

(12) **EUROPEAN PATENT APPLICATION**
published in accordance with Art. 153(4) EPC

(43) Date of publication:
**02.07.2025 Bulletin 2025/27**

(21) Application number: 23856991.7

(22) Date of filing: **04.07.2023**

(51) International Patent Classification (IPC):
*G01R 31/389* (2019.01)    *G01R 31/382* (2019.01)
*G01R 31/385* (2019.01)    *H01M 10/48* (2006.01)
*H02J 7/00* (2006.01)

(52) Cooperative Patent Classification (CPC):
**G01R 31/382; G01R 31/385; G01R 31/389;
H01M 10/48; H02J 7/00;** Y02E 60/10

(86) International application number:
**PCT/JP2023/024783**

(87) International publication number:
**WO 2024/042874 (29.02.2024 Gazette 2024/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.08.2022 JP 2022134773**

(71) Applicant: **Panasonic Intellectual Property
Management Co., Ltd.
Kadoma-shi, Osaka 571-0057 (JP)**

(72) Inventors:
• **MATSUI, Tooru**
  **Kadoma-shi, Osaka 571-0057 (JP)**
• **HIBINO, Mitsuhiro**
  **Kadoma-shi, Osaka 571-0057 (JP)**
• **SUZUKI, Hirotetsu**
  **Kadoma-shi, Osaka 571-0057 (JP)**
• **NAKURA, Kensuke**
  **Kadoma-shi, Osaka 571-0057 (JP)**

(74) Representative: **Novagraaf International SA
Chemin de l'Echo 3
1213 Onex, Geneva (CH)**

(54) **METHOD FOR MEASURING INTERNAL RESISTANCE OF BATTERY**

(57)     The disclosed method is a method for measuring the internal resistance of a battery. The measurement method includes a conduction step of charging or discharging the battery, a measurement step of measuring an open circuit voltage of the battery at the end time of the charging or discharging and thereafter, and a calculation step of individually calculating at least one resistance component included in the internal resistance, based on a voltage change of the open circuit voltage measured in the measurement step and a current value of current flowing through the battery for the charging or discharging at the end time. In the calculation step, the at least one resistance component is calculated based on a slope of a line obtained by plotting the voltage change in a graph in which a horizontal axis indicates a square root of an elapsed time from the end time and a vertical axis indicates the open circuit voltage.

FIG. 1

EP 4 579 258 A1

**Description**

[Technical Field]

The present disclosure relates to a method for measuring the internal resistance of a battery.

[Background Art]

The internal resistance of a battery is particularly important for evaluating the performance and state (for example, deterioration state) of the battery. Therefore, there have been conventionally proposed methods for measuring the internal resistance.

PTL 1 (Japanese Laid-Open Patent Publication No. 2017-111860) discloses a "secondary battery control system including: a data accumulation unit that acquires and accumulates usage history data of a secondary battery including the current and voltage of the secondary battery corresponding to the usage time of the secondary battery; a data selection unit that selects a predetermined range of data from the usage history data accumulated in the data accumulation unit; an internal deterioration parameter calculation unit that calculates internal deterioration parameters corresponding to the capacity and deterioration state of internal resistance of the secondary battery based on the data selected by the data selection unit; and a deterioration state estimation unit that estimates the deterioration state of the secondary battery based on the internal deterioration parameters calculated by the internal deterioration parameter calculation unit".

PTL 2 (WO 2020/012720) discloses "a secondary battery parameter estimation device including: a voltage acquisition unit that acquires the voltage of a secondary battery; a current acquisition unit that acquires the current of the secondary battery; a parameter estimation unit that estimates a plurality of parameters including the internal resistance of the secondary battery in an equivalent circuit model corresponding to the secondary battery, based on the voltage acquired by the voltage acquisition unit and the current acquired by the current acquisition unit; an internal resistance derivation unit that derives the internal resistance of the secondary battery by a method different from the method of estimation performed by the parameter estimation unit; and a determination unit that determines whether to replace parameters of the secondary battery with the plurality of parameters estimated by the parameter estimation unit, based on the result of a comparison between the internal resistance estimated by the parameter estimation unit and the internal resistance derived by the internal resistance derivation unit".

[Citation List]

[Patent Literature]

PTL 1: Japanese Laid-Open Patent Publication No. 2017-111860
PTL 2: WO 2020/012720

[Summary of Invention]

[Technical Problem]

There have been conventionally proposed various methods for measuring the internal resistance of a battery. However, according to the conventional methods, it is difficult to individually measure resistance components constituting the internal resistance of a battery in a simple manner. In view of such circumstances, an object of the present disclosure is to provide a measurement method that makes it possible to individually measure resistance components constituting the internal resistance of a battery in a simple manner.

[Solution to Problem]

One aspect of the present disclosure relates to a method for measuring the internal resistance of a battery. The measurement method includes a conduction step of charging or discharging the battery, a measurement step of measuring an open circuit voltage of the battery at an end time of the charging or discharging and thereafter, and a calculation step of individually calculating at least one resistance component included in the internal resistance, based on a voltage change of the open circuit voltage measured in the measurement step and a current value of current flowing through the battery for the charging or discharging at the end time, wherein in the calculation step, the at least one resistance component is calculated based on a slope of a line obtained by plotting the voltage change in a graph in which a horizontal axis indicates a square root of an elapsed time from the end time and a vertical axis indicates the open circuit voltage.

[Advantageous Effects of Invention]

According to the measurement method of the present disclosure, it is possible to individually measure resistance components constituting the internal resistance of a battery in a simple manner.

Novel features of the present invention are set forth in the appended claims, but the present invention, both in terms of its configuration and content, together with other objects and features of the present invention, will be better understood from the following detailed description taken in conjunction with the drawings.

[Brief Description of Drawings]

FIG. 1 is a diagram for describing a measurement method according to the present disclosure.
FIG. 2 is a diagram for describing an example of the measurement method carried out in Example 1.
FIG. 3 is a diagram for describing a measurement method carried out in Example 2.
FIG. 4 is a diagram showing measurement results of Example 2.

[Description of Embodiments]

Hereinafter, embodiments according to the present disclosure will be described with examples, but embodiments according to the present disclosure are not limited to the examples described below. In the following description, specific numerical values and materials may be exemplified, but other numerical values and other materials may be applied as long as the invention according to the present disclosure can be implemented. The description "numerical value A to numerical value B" herein includes numerical value A and numerical value B and can also be read as "numerical value A or more and numerical value B or less." In the following description, when lower limits and upper limits are exemplified for numerical values of specific physical properties or conditions, any of the exemplified lower limits and any of the exemplified upper limits can be combined as desired as long as the lower limit is not equal to or greater than the upper limit.

(Method for Measuring Internal Resistance of Battery)

The measurement method according to the present embodiment is a method for measuring an internal resistance R of a battery. This measurement method will also be referred to as "measurement method (M)" below. There is no particular limit on batteries whose internal resistance can be measured by the measurement method (M). Examples of batteries measured by the measurement method (M) include secondary batteries and primary batteries. There is no particular limit on the secondary batteries and primary batteries measured. Examples of the secondary batteries measured include lithium ion batteries, lithium metal secondary batteries, sodium metal secondary batteries, nickel hydrogen batteries, lead acid batteries, and the like. Examples of the primary batteries measured include manganese dry batteries, alkaline dry batteries, air batteries, and the like.

The measurement method (M) includes three steps: a conduction step, a measurement step, and a calculation step, which will be described below.

(Conduction Step)

The conduction step is a step of charging or discharging a battery to be measured. It is preferable that the current value (charging or discharging current value) in the conduction step is not changed immediately before the end of the conduction step. In order to perform a highly reliable measurement, the current value in the conduction step is preferably constant for 10 seconds before the end time. A current value Ie (charging or discharging current value) at the end of the conduction step may be in the range of 0.01 to 100 times (for example, 0.1 to 10 times) 1C of the battery. Setting the current value Ie in this range makes it possible to perform a particularly reliable measurement. 1C refers to the current value at a 1-hour rate. The current value 1C is calculated by the formula 1C (A) = rated capacity (Ah)/1 (h).

(Measurement Step)

The measurement step is a step of measuring an open circuit voltage Vop of the battery at the end time of charging or discharging in the conduction step and thereafter. At the end of the conduction step, the open circuit voltage Vop of the battery changes over time. In the measurement step, the voltage change is measured over time.

(Calculation Step)

The calculation step is a step of individually calculating at least one resistance component Re included in the internal resistance R based on a voltage change Vch (volts) of the open circuit voltage Vop (volts) measured in the measurement step and the current value Ie (amperes) of the current flowing through the battery for the charging or discharging at the end time. In the calculation step, the at least one resistance component Re is calculated based on the slope of a line (hereinafter also referred to as "line L") obtained by plotting the voltage change Vch in a graph in which the horizontal axis indicates a square root TR of an elapsed time T from the end time and the vertical axis indicates the open circuit voltage Vop.

As a result of various studies, the inventors of the present application have newly found that resistance components constituting the internal resistance R can be calculated individually from the above line L. The present disclosure is based on this new finding. According to the method of the present disclosure, it is possible to individually calculate a plurality of resistance components. In other words, according to the method of the present disclosure, it is possible to divide the internal resistance into a plurality of resistance components and calculate the resistance components. According to the method of the present disclosure, the magnitudes of the different resistance components can be known, which is particularly useful for evaluating the performance and state (for example, deterioration state) of the battery. In addition, it is possible to easily measure the internal resistance R and the resistance components constituting the internal resistance R.

According to the measurement method (M), the proportion of each resistance component can be known. Based on the proportion of each resistance component, it is possible to evaluate the performance of the battery and estimate the deterioration state of the battery in more detail. Also, based on the absolute value of each resistance component, it is possible to evaluate the performance of the battery and estimate the deterioration state of the battery in more detail.

The resistance component Re can be calculated using the current value Ie and a plurality of voltage values (hereinafter, also referred to as "voltage values V(I)"). The plurality of voltage values V(I) include the voltage values below. The sign I in V(I) represents the order of the voltage values, and the voltage values are indicated as V(1), V(2), ... starting from a reference voltage value V(0).

(1) The reference voltage value (hereinafter, also referred to as "reference voltage value V(0)") which is the open circuit voltage at the end of the conduction step.
(2) At least one voltage value V(I) (where $1 \leq I$) obtained by extrapolating in the graph at least one straight line SL along at least one straight portion appearing on the line L to the end of the conduction step. The end of the conduction step here is the origin of the horizontal axis in the graph (the square root TR of the elapsed time T = 0).

The voltage values V(I) (where $1 \leq I$) are determined based on the slope of the straight portion of the line L. The at least one straight line SL may be one line, two or more lines, or four or fewer (for example, three or fewer, or two or fewer) lines. If there is one straight line SL, it is preferable to draw a straight line along a straight portion where the square root TR of the elapsed time T (seconds) is in the range of 0 to 3 ($s^{1/2}$). Drawing such a straight line SL makes it possible to calculate resistance components with a fast response speed.

According to the measurement method (M), the internal resistance R (the total value of all the resistance components Re) can also be obtained. In this case, the straight line SL is drawn along the portion of the line L that no longer has a voltage change and is substantially parallel to the horizontal axis, and the voltage value V(I) is obtained using the straight line SL. Then, the internal resistance R can be obtained by using the reference voltage value V(0), the voltage values V(I), and the current value Ie. Alternatively, the internal resistance R may be obtained by summing up the resistance components Re.

The straight line SL may include a straight line along a straight portion in which the square root TR of the elapsed time T (seconds) is in the range of 0 to 3 ($s^{1/2}$) and a straight line that no longer has a voltage change and is substantially parallel to the horizontal axis. From these straight lines, resistance components with a fast response speed and the internal resistance R can be calculated.

The following methods can be used to draw the straight line SL by identifying the straight portion of the line L. A first method is to draw a straight line while visually identifying the straight portion. A second method is to determine a range in which the value obtained by differentiating the line L with $s^{1/2}$ is constant, and draw the straight line. A third method is to overlap and fit a plurality of functions in which the voltage change is proportional to $s^{1/2}$ as the square root TR becomes smaller. In the case of focusing on a portion related to electronic resistance with a sudden voltage change, it is possible to use a method in which a regression line is drawn based on a plurality of voltage values measured within several tens of milliseconds after the end of the conduction step.

In the measurement method (M), the resistance components can be obtained by dividing the voltage difference between two voltage values (for example, two adjacent voltage values) among the plurality of voltage values V(I) by the current value Ie.

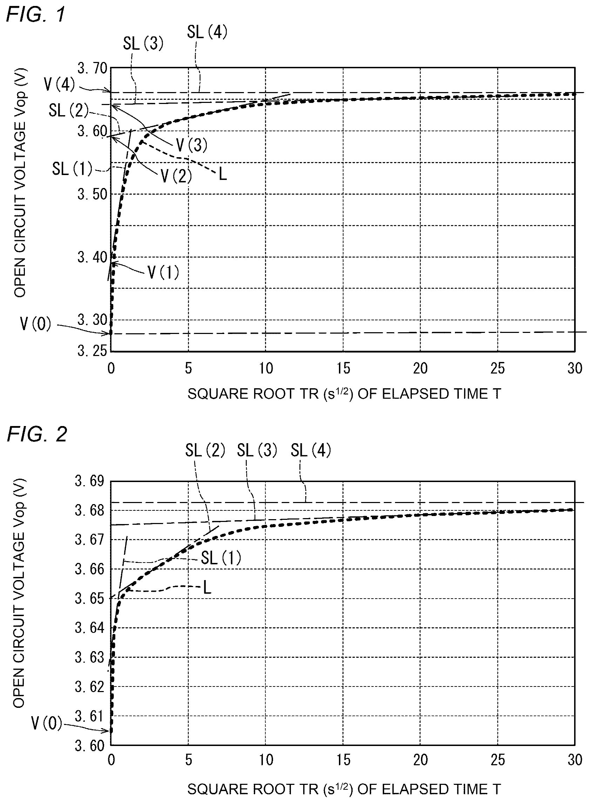

An example of a method for calculating the internal resistance R and the resistance components Re will be described with reference to the drawings. FIG. 1 is a graph showing the change over time in the open circuit voltage Vop after discharging a secondary battery at the current value Ie (amperes). The graph in FIG. 1 is a graph of measurement after a charge-discharge cycle test of a secondary battery of Example 1 described later. The vertical axis indicates the open circuit voltage Vop (volts). The horizontal axis indicates the square root TR ($s^{1/2}$) of the elapsed time T (seconds: s) from the end time of discharge. The position of 0 on the horizontal axis indicates the end time of discharge. The elapsed time at the position of 10 on the horizontal axis is 100 seconds, and the elapsed time at the position of 30 on the horizontal axis is 900 seconds.

A line L in FIG. 1 is a line obtained by plotting voltage change in the open circuit voltage Vop. As shown in FIG. 1, the line L has four straight portions, and four straight lines SL(1) to SL(4) are drawn along the straight portions. The straight line SL(4) shows the values after 3600 seconds under which there is substantially no change in the open circuit voltage Vop.

The open circuit voltage Vop with the square root TR of 0 is the reference voltage value V(0). Voltage values V(1) to V(4) shown in FIG. 1 are the voltage values obtained when the straight lines SL(1) to SL(4) are extrapolated to the end time of discharge (the square root TR = 0). In other words, the voltage values V(I) (where $1 \leq I$) are the voltage values at the intersection of an extension of the straight line SL(I) and the vertical axis (Y axis) at TR = 0.

In the example of FIG. 1, it is possible to determine four resistance components Re(1) to Re(4). Re(1) can be determined from the following formula:

$$Re(1) \, (\Omega) = (V(1) - V(0))/Ie$$

That is, the first resistance component Re(1) is calculated by dividing the voltage difference between two adjacent voltage values V(0) and V(1) among the plurality of voltage values by the current value Ie. Similarly, each resistance component Re(I) is calculated by the following formula:

$$Re(I) = (V(I) - V(I - 1))/Ie$$

The internal resistance R of the entire battery may be calculated by adding up the resistance components, or by using the following formula: R = (V(4) - V(0))/Ie

Re(1) is thought to be a resistance component with a particularly fast response, and a resistance component related electrons and an electrolyte, that is to say electron transfer in an electrode constituted of an active material layer and a current collector, and the mobility of ions in an electrolyte. Re(2) is thought to be a resistance component with a fast response, and a charge transfer resistance component, that is, a resistance component related to the reaction between an active material and ions in the electrolyte. Re(3) may be a resistance component related to the process of ions being transported in voids that are present in the electrode and filled with the electrolyte. Re(4) may be a resistance component related to the process of ions diffusing in a solid active material. It is not necessary to draw the straight line SL along all the straight portions and calculate the corresponding resistance components, and only the required resistance components may be calculated. For example, only the resistance components with a particularly fast response may be calculated. For example, the straight line SL may be drawn along the straight portions present in the region where the square root TR is $3(s^{1/2})$ or less, and only the resistance components with a particularly fast response may be calculated.

In the measurement method (M), the open circuit voltage Vop may be measured at predetermined time intervals or each time the voltage change reaches a predetermined value in the measurement step. The predetermined time interval may be in the range of 0.001 to 10 seconds (for example, the range of 0.1 to 1 second). The predetermined value of the voltage change may be in the range of 0.1 to 100 mV (for example, the range of 1 to 10 mV).

In the measurement method (M), in the measurement step, the open circuit voltage Vop may be measured every 0.1 seconds or every time the voltage change reaches 5 mV, until at least 10 seconds have elapsed from the end time of charging or discharging. After that, the measurement interval may be made wider, or the measurement may be continued at the same measurement intervals.

The present disclosure provides a measurement apparatus that measures the internal resistance of a battery using the measurement method (M). The measurement apparatus has a configuration for executing the measurement method (M). For example, the measurement apparatus may include a device for charging and discharging a battery (device for performing the conduction step), a device for measuring the open circuit voltage of the battery (device for performing the measurement step), and a device for calculating the internal resistance (resistance component) by analyzing the measured value (device for performing the calculation step). The device for charging and discharging the battery and the device for measuring the open circuit voltage of the battery are not particularly limited, and known devices may be used. The device for performing the calculation step may include an arithmetic processing device and a storage device. The storage device stores a program for performing the above-described calculation step. The storage device further stores the measured value obtained in the measurement step. The arithmetic processing device executes the stored program and calculates the internal resistance (resistance components) based on the measured value. The storage device may store programs for performing the conduction step and the measurement step in a predetermined order. The arithmetic processing device can control the devices based on those programs.

(Additional Remarks)

The above description discloses the following techniques:

(Technique 1)

A method for measuring an internal resistance of a battery, comprising:

a conduction step of charging or discharging the battery;
a measurement step of measuring an open circuit voltage of the battery at the end time of the charging or discharging and thereafter; and
a calculation step of individually calculating at least one resistance component included in the internal resistance, based on a voltage change of the open circuit voltage measured in the measurement step and a current value of current flowing through the battery for the charging or discharging at the end time,
wherein in the calculation step, the at least one resistance component is calculated based on a slope of a line obtained by plotting the voltage change in a graph in which a horizontal axis indicates a square root of an elapsed time from the end time and a vertical axis indicates the open circuit voltage.

(Technique 2)

The measurement method according to Technique 1,

wherein the resistance component is calculated using the current value and a plurality of voltage values, and the plurality of voltage values include:

a reference voltage value that is the open circuit voltage at the end time; and
at least one voltage value obtained by extrapolating at least one straight line along at least one straight portion that appears on the line to the end time in the graph.

(Technique 3)

The measurement method according to Technique 2, wherein the resistance component is determined by dividing a voltage difference between two adjacent voltage values among the plurality of voltage values by the current value.

(Technique 4)

The measurement method according to any one of Techniques 1 to 3, wherein in the measurement step, the open circuit voltage is measured at predetermined time intervals or every time the voltage change reaches a predetermined value.

(Technique 5)

The measurement method according to any one of Techniques 1 to 4, wherein in the measurement step, the open circuit voltage is measured every 0.1 seconds or every time the voltage change reaches 5 mV, until at least 10 seconds have elapsed from the end time.

Examples

Hereinafter, the present disclosure will be described in more detail with reference to examples.

(Example 1)

In Example 1, a charge-discharge cycle test was performed on a secondary battery in which a layered oxide material containing Li, Ni, and Mn was used as a positive electrode active material and a lithium metal was used as a negative electrode active material. The charge-discharge cycle test was performed by repeating charging at a current value of 0.7 C and discharging at a current value of 0.15 C. Then, the secondary battery was measured using the measurement method (M) before and after the charge-discharge cycle test.

FIG. 2 shows a graph obtained by the measurement step of the measurement method (M) before the charge-discharge cycle test. The graph in FIG. 2 is a graph showing the change over time of the open circuit voltage Vop after the secondary battery was charged to 3.7 V at a current value of 0.7 C and then discharged for 1051 seconds at a current value of 0.15 C (current value Ie). A line L in FIG. 2 is a line obtained by plotting the voltage change of the open circuit voltage Vop. FIG. 1 shows the change over time of the open circuit voltage Vop after the charge-discharge cycle test.

As in FIG. 1, the line L in FIG. 2 has four straight portions, along which four straight lines SL(1) to SL(4) are drawn. The straight line SL(4) indicates the value after 3600 seconds under which no substantial change was observed in the open circuit voltage Vop. The straight lines SL(1) to SL(4) were then extrapolated to the end time of discharge (square root TR = 0) to determine voltage values V(1) to V(4) (not shown). The internal resistance R and the first to fourth resistance components Re(1) to Re(4) were calculated by the above-described method from the reference voltage value V(0), which was the open circuit voltage Vop at the end time of discharge, and the voltage values V(1) to V(4).

Furthermore, the internal resistance R and resistance components Re(1) to Re(4) of the secondary battery after the charge-discharge cycle test were calculated based on the graph shown in FIG. 1. Table 1 shows the calculation results.

[Table 1]

|  | Resistance value ($\Omega$) | | | | |
|---|---|---|---|---|---|
|  | Re(1) | Re(2) | Re(3) | Re(4) | Internal resistance R |
| Before charge-discharge cycle test | 22.2 | 15.0 | 20.4 | 6.5 | 64 |
| After charge-discharge cycle test | 94.4 | 160.6 | 40.7 | 15.7 | 311 |

As shown in Table 1, the charge-discharge cycle test revealed that, among the resistance components, the resistance components Re(1) and Re(2) increased significantly.

(Example 2)

In Example 2, the internal resistance was measured by the measurement method (M) while changing the state of charge (SOC) of the secondary battery. The secondary battery was assembled in the same manner as in Example 1, except that the restraining pressure was increased by 2.7 times. Then, charging at a current value of 0.7 C and discharging at a current value of 0.15 C were repeated.

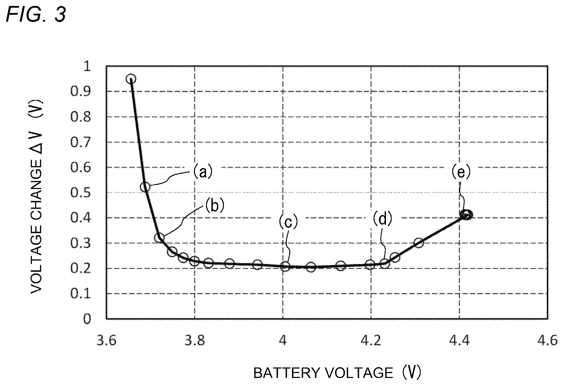

Next, the secondary battery was charged to change the state of charge. Then, in different states of charge, the secondary battery was discharged at a current value of 1C for 30 seconds, and the voltage change after discharge was measured. In addition, the internal resistance of the secondary battery was calculated by the measurement method (M). FIG. 3 shows the voltage change before and after discharge in each state of charge. The higher the battery voltage on the horizontal axis in FIG. 3, the higher the state of charge.

Table 2 shows the calculation results for the resistance of the secondary battery at points (a) to (e) in FIG. 3.

[Table 2]

|  | Resistance value ($\Omega$) | | | | |
|---|---|---|---|---|---|
|  | Re(1) | Re(2) | Re(3) | Re(4) | Internal resistance R |
| Point (a) | 19.9 | 26 | 10.7 | 0.9 | 57 |
| Point (b) | 17.3 | 7.6 | 9.6 | 0.6 | 35 |
| Point (c) | 11.4 | 1.9 | 8.2 | 0.5 | 22 |
| Point (d) | 11.3 | 3.6 | 8.4 | 0.6 | 24 |
| Point (e) | 11.1 | 7.9 | 20.9 | 2.1 | 42 |

As shown in Table 2, the resistance component Re(2) changed in a U-shape with the change in the state of charge. In addition, in the fully charged state, the resistance components Re(3) and Re(4) increased significantly.

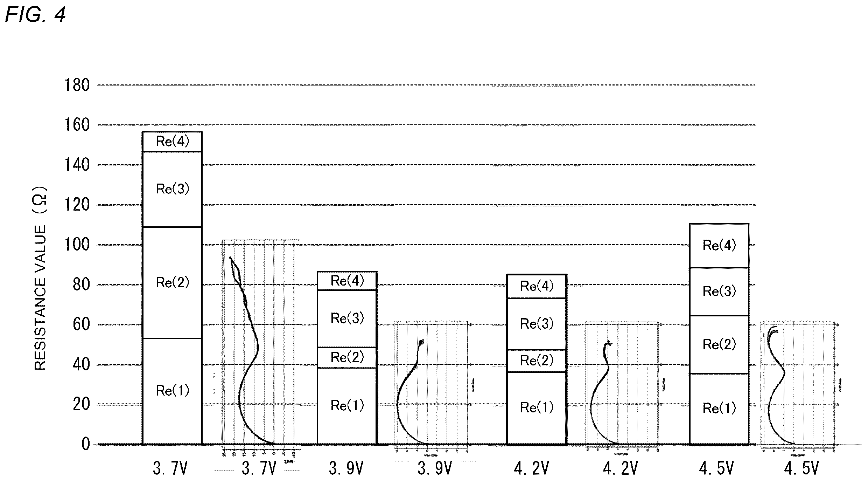

The battery voltage was set to 3.7 V, 3.9 V, 4.2 V, and 4.5 V, and the resistance components of the internal resistance were calculated at each voltage by the measurement method (M). Specifically, at each voltage, the battery was discharged at a current value of 0.15 C for 1051 seconds, and measured by the measurement method (M). During the discharge, the AC impedance was measured. FIG. 4 shows the results of the calculation of the internal resistance by the measurement method (M). Note that FIG. 4 shows the Nyquist plots of measurements at the respective voltages rotated 90° counterclockwise.

As shown in FIG. 4, the internal resistance R at 3.7 V is 157 $\Omega$, which is approximately half that of the secondary battery in Example 1.

It is thought from FIG. 4 that the resistance component Re(1) corresponds to the arc on the high-frequency side of the Nyquist plot, and the resistance component Re(2) corresponds to the arc on the low-frequency side of the Nyquist plot. The resistance components Re(3) and Re(4) may correspond to resistance related to ion transport and diffusion resistance.

(Example 3)

In Example 3, a charge-discharge cycle test was performed on a secondary battery using a layered oxide material containing Li, Ni, Co, and Al as a positive electrode active material and a mixture of graphite and silicon as a negative electrode active material. The charge-discharge cycle test was performed by repeating charging at a current value of 0.7 C and discharging at a current value of 0.15 C. The battery was then charged to 3.8 V, discharged at a current value of 0.15 C for 1051 seconds, and then measured by the measurement method (M). Table 3 shows the calculated results of the resistance of this secondary battery.

[Table 3]

| Battery voltage during charging | Resistance value ($\Omega$) | | | |
|---|---|---|---|---|
| | Re(1) | Re(2) | Re(3) | Internal resistance R |
| 3.8 V | 0.839 | 0.308 | 0.607 | About 1.8 |

In this battery, the open circuit voltage Vop continued to change even 3600 seconds after the end time of discharge, and therefore the resistance component Re(4) was not able to be calculated, whereas the resistance components Re(1) to Re(3) were calculated.

Industrial Applicability

The present disclosure can be used for a method for measuring the internal resistance of a battery.

Although the present invention has been described with reference to the presently preferred embodiments, such disclosure should not be interpreted as being limited. Various modifications and alterations will undoubtedly become apparent to those skilled in the art to which the present invention pertains upon reading the above disclosure. Therefore, the appended claims should be interpreted to cover all modifications and alterations without departing from the true spirit and scope of the present invention.

**Claims**

1.   A method for measuring an internal resistance of a battery, the measurement method comprising:

a conduction step of charging or discharging the battery;
a measurement step of measuring an open circuit voltage of the battery at an end time of the charging or discharging and thereafter; and
a calculation step of individually calculating at least one resistance component included in the internal resistance, based on a voltage change of the open circuit voltage measured in the measurement step and a current value of current flowing through the battery for the charging or discharging at the end time,
wherein in the calculation step, the at least one resistance component is calculated based on a slope of a line obtained by plotting the voltage change in a graph in which a horizontal axis indicates a square root of an elapsed time from the end time and a vertical axis indicates the open circuit voltage.

2. The measurement method according to claim 1,

wherein the resistance component is calculated using the current value and a plurality of voltage values, and the plurality of voltage values includes:

a reference voltage value that is the open circuit voltage at the end time; and
at least one voltage value that is obtained by extrapolating at least one straight line along at least one straight portion appearing in the line to the end time in the graph.

3. The measurement method according to claim 2, wherein the resistance component is determined by dividing a voltage difference between two adjacent voltage values among the plurality of voltage values by the current value.

4. The measurement method according to claim 1 or 2, wherein in the measurement step, the open circuit voltage is measured at predetermined time intervals or each time the voltage change reaches a predetermined value.

5. The measurement method according to claim 1 or 2, wherein in the measurement step, the open circuit voltage is measured every 0.1 seconds or every time the voltage change reaches 5 mV, until at least 10 seconds have elapsed from the end time.

*FIG. 1*

*FIG. 2*

FIG. 3

EP 4 579 258 A1

FIG. 4

# EP 4 579 258 A1

## INTERNATIONAL SEARCH REPORT

International application No.

**PCT/JP2023/024783**

### A. CLASSIFICATION OF SUBJECT MATTER

***G01R 31/389***(2019.01)i; ***G01R 31/382***(2019.01)i; ***G01R 31/385***(2019.01)i; ***H01M 10/48***(2006.01)i; ***H02J 7/00***(2006.01)i
FI:   G01R31/389; G01R31/382; G01R31/385; H01M10/48 P; H02J7/00 Y

According to International Patent Classification (IPC) or to both national classification and IPC

### B. FIELDS SEARCHED

Minimum documentation searched (classification system followed by classification symbols)

G01R31/389; G01R31/382; G01R31/385; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2013-44598 A (TOYOTA MOTOR CORP) 04 March 2013 (2013-03-04)<br>    paragraphs [0138]-[0139], fig. 14 | 1-5 |
| A | WO 2020/012720 A1 (SUMITOMO ELECTRIC INDUSTRIES, LTD.) 16 January 2020 (2020-01-16) | 1-5 |
| A | US 2015/0212160 A1 (INFINEON TECHNOLOGIES AG) 30 July 2015 (2015-07-30) | 1-5 |
| A | WO 2009/118910 A1 (SHIN-KOBE ELECTRIC MACHINERY CO., LTD.) 01 October 2009 (2009-10-01) | 1-5 |
| A | WO 2018/051613 A1 (PANASONIC INTELLECTUAL PROPERTY MANAGEMENT CO., LTD.) 22 March 2018 (2018-03-22) | 1-5 |
| A | WO 2017/169088 A1 (PANASONIC INTELLECTUAL PROPERTY MANAGEMENT CO., LTD.) 05 October 2017 (2017-10-05) | 1-5 |
| A | JP 2011-54413 A (NISSAN MOTOR CO LTD) 17 March 2011 (2011-03-17) | 1-5 |
| A | JP 2017-227631 A (TOYOTA IND CORP) 28 December 2017 (2017-12-28) | 1-5 |

☑ Further documents are listed in the continuation of Box C.    ☑ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **14 August 2023** | **29 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2023/024783**

### C. DOCUMENTS CONSIDERED TO BE RELEVANT

| Category* | Citation of document, with indication, where appropriate, of the relevant passages | Relevant to claim No. |
|---|---|---|
| A | JP 2014-25739 A (SANYO ELECTRIC CO LTD) 06 February 2014 (2014-02-06) | 1-5 |
| A | JP 2018-169183 A (TOYOTA IND CORP) 01 November 2018 (2018-11-01) | 1-5 |

Form PCT/ISA/210 (second sheet) (January 2015)

## INTERNATIONAL SEARCH REPORT
### Information on patent family members

International application No.

**PCT/JP2023/024783**

| Patent document cited in search report | | | Publication date (day/month/year) | Patent family member(s) | | | Publication date (day/month/year) |
|---|---|---|---|---|---|---|---|
| JP | 2013-44598 | A | 04 March 2013 | (Family: none) | | | |
| WO | 2020/012720 | A1 | 16 January 2020 | US | 2021/0123980 | A1 | |
| | | | | CN | 112384814 | A | |
| US | 2015/0212160 | A1 | 30 July 2015 | DE | 102014101157 | A1 | |
| | | | | CN | 104820188 | A | |
| WO | 2009/118910 | A1 | 01 October 2009 | (Family: none) | | | |
| WO | 2018/051613 | A1 | 22 March 2018 | (Family: none) | | | |
| WO | 2017/169088 | A1 | 05 October 2017 | US | 2019/0025381 | A1 | |
| | | | | CN | 108780931 | A | |
| JP | 2011-54413 | A | 17 March 2011 | (Family: none) | | | |
| JP | 2017-227631 | A | 28 December 2017 | (Family: none) | | | |
| JP | 2014-25739 | A | 06 February 2014 | (Family: none) | | | |
| JP | 2018-169183 | A | 01 November 2018 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017111860 A

- WO 2020012720 A